(19) Europäisches Patentamt / European Patent Office / Office européen des brevets

(11) **EP 2 470 922 B1**

(12) **FASCICULE DE BREVET EUROPEEN**

(45) Date de publication et mention
de la délivrance du brevet:
**13.01.2016 Bulletin 2016/02**

(21) Numéro de dépôt: **10763759.7**

(22) Date de dépôt: **27.08.2010**

(51) Int Cl.:
*G01R 33/383* (2006.01)   *H01F 7/02* (2006.01)

(86) Numéro de dépôt international:
**PCT/FR2010/051783**

(87) Numéro de publication internationale:
**WO 2011/023912 (03.03.2011 Gazette 2011/09)**

(54) **ASSEMBLAGE DE STRUCTURES AIMANTEES COAXIALES INDUISANT EN SON CENTRE UN CHAMP HOMOGENE LONGITUDINAL**

ANORDNUNG VON MAGNETISIERTEN KOAXIALSTRUKTUREN MIT EINEM HOMOGENEN LÄNGSFELD IN DER MITTE

ASSEMBLY OF MAGNETISED COAXIAL STRUCTURES INDUCING A LONGITUDINAL HOMOGENEOUS FIELD IN THE CENTRE THEREOF

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **28.08.2009 FR 0955891**

(43) Date de publication de la demande:
**04.07.2012 Bulletin 2012/27**

(73) Titulaire: **Commissariat à l'Énergie Atomique et aux Énergies Alternatives
75015 Paris (FR)**

(72) Inventeurs:
• **SAKELLARIOU, Dimitrios**
  **F-92100 Boulogne Billancourt (FR)**
• **HUGON, Cedric**
  **F-92140 Clamart (FR)**
• **AUBERT, Guy**
  **F-86000 Poitiers (FR)**

(74) Mandataire: **Thévenet, Jean-Bruno et al
Cabinet Beau de Loménie
158, rue de l'Université
75340 Paris Cédex 07 (FR)**

(56) Documents cités:
WO-A1-2006/024775    FR-A- 1 100 721
US-A- 5 014 032    US-A- 6 163 240

**Description**

Domaine de l'invention

La présente invention a pour objet une structure aimantée induisant dans une zone d'intérêt centrale un champ magnétique homogène orienté selon un axe longitudinal de la structure, comprenant des première et deuxième couronnes aimantées disposées de façon symétrique par rapport à un plan qui est perpendiculaire audit axe longitudinal et contient ladite zone d'intérêt centrale, et une structure aimantée annulaire médiane interposée entre les première et deuxième couronnes aimantées et également disposée de façon symétrique par rapport audit plan, la première couronne étant aimantée radialement par rapport à l'axe longitudinal avec une aimantation divergente, la deuxième couronne étant aimantée radialement par rapport à l'axe longitudinal avec une aimantation convergente, et la structure annulaire médiane étant aimantée selon l'axe longitudinal.

Art antérieur

Dans le domaine de la Résonance Magnétique Nucléaire (RMN), l'échantillon (objet ou patient) est placé à l'intérieur d'un champ magnétique qui doit être très intense et très homogène. Il convient donc de pouvoir fabriquer des structures aimantées capables de produire de tels champs magnétiques.

Les aimants utilisés actuellement en RMN pour créer des champs intenses et homogènes sont, pour la plus grande majorité, basés sur la circulation de courant dans des bobines. Que les bobines soient résistives ou supraconductrices, il y a toujours nécessité d'approvisionner l'aimant en courant et également en fluides cryogéniques dans le cas des bobines supraconductrices. Les appareils sont de ce fait encombrants et difficilement déplaçables. Des bobines résistives nécessitent d'importantes amenées de courant tandis que des bobines supraconductrices impliquent l'utilisation d'un cryostat rempli de liquides cryogéniques, qui est difficile à déplacer.

Une structure basée sur des aimants permanents permet de s'affranchir de ces contraintes puisque le matériau est aimanté une fois pour toutes et, s'il est manipulé de manière appropriée, conserve son aimantation sans maintenance extérieure. Par ailleurs, les matériaux dits permanents sont limités en rémanence (l'aimantation subsistant dans le matériau une fois aimanté) et la génération de champs importants dans de grandes zones utiles nécessite de grandes quantités de matière. La densité de ces matériaux étant d'environ 7.5 g cm$^{-3}$, on aboutit rapidement à des systèmes très lourds. Il est donc important de minimiser la quantité de matériau pour un champ donné.

La difficulté des systèmes magnétiques en matériaux permanents pour la RMN réside dans le besoin de coupler champs intenses avec forte homogénéité. Les procédés de fabrication des matériaux comme le NdFeB ne permettent pas de garantir une parfaite homogénéité d'aimantation, ni une parfaite répétitivité. Aussi, bien qu'il soit possible de calculer des structures fournissant l'homogénéité désirée, il est nécessaire de ménager des possibilités de réglages *a posteriori* qui permettent de corriger les imperfections du matériau.

La forme d'ensemble pour ces structures aimantées est généralement le cylindre, où la structure adopte au moins une symétrie axiale. Ceci permet de s'affranchir de nombreux facteurs d'inhomogénéité. La zone d'intérêt se trouve alors au centre du cylindre et l'accès à cette zone peut se faire selon l'axe en dégageant un trou dans le cylindre, ou alors par le côté en séparant le cylindre en deux.

Très peu de structures à base d'aimant permanent ont été proposées dans le passé pour générer un champ homogène longitudinal au centre. Ceci est dû au fait que les applications RMN qui nécessitent une grande homogénéité demandent aussi aux appareils d'être soit très grands (cas de l'IRM où un corps humain doit rentrer dans l'appareil), ce qui implique une énorme quantité de matériau (plusieurs tonnes), soit très intenses (c'est le cas de la spectroscopie RMN qui utilise des champs supérieurs à 10 T, jusqu'à 20 T pour le moment), ce qui n'est tout simplement pas réalisable à l'heure actuelle avec des matériaux permanents.

Ainsi, le plus ancien brevet concernant une structure cylindrique d'aimants permanents générant un champ longitudinal homogène capable *a priori* d'effectuer de la RMN est celui de Guy Aubert datant de 1991 (brevet US-A-5 014 032). Celui-ci propose d'utiliser des anneaux en matériau permanent, aimantés radialement. Les anneaux sont aimantés vers l'axe de symétrie d'un côté de la zone utile et vers l'extérieur de l'autre côté de la zone utile. La structure est symétrique par rapport au plan orthogonal à l'axe de symétrie et contenant le centre de la zone utile.

Il y a aujourd'hui un regain d'intérêt pour les structures à base de matériaux permanents car ils se trouvent très adaptés pour les applications de RMN à bas champ, portables ou transportables. De plus, les nouveaux matériaux magnétiques offrent des rémanences et coercivités bien plus élevées, permettant des champs induits suffisants (des centaines de mT) pour trouver des applications en RMN. Enfin, ces matériaux se prêtent facilement à la rotation, ce qui permettrait d'obtenir une amélioration de la résolution, à l'instar de la méthode proposée par Bloch (brevet US-A-2 960 649), cette fois en faisant tourner le champ et non l'échantillon.

Heninger *et al* ont proposé en 2006 une structure pour générer un champ longitudinal dans le contexte d'un piège à ions (demande de brevet WO 2006/024775). Cet aimant permet une homogénéité de 1 pour mille dans un

volume de 10 cm$^3$ avec un champ de 1T. Cette structure ne permet donc pas une homogénéité telle que celle requise par la RMN mais produit un champ comparable en magnitude à celui de certains imageurs médicaux (1.5 T). Par ailleurs la structure proposée n'est pas simple à fabriquer.

Définition et objet de l'invention

La présente invention vise à remédier aux inconvénients mentionnés plus haut et à offrir une solution pour remédier notamment à la difficulté d'assemblage des pièces aimantées afin de former des aimants permanents puissants capables de créer un champ homogène et intense au centre de la structure aimantée, le champ induit étant orienté selon l'axe longitudinal de la structure.

L'invention peut entre autres trouver des applications dans les domaines de la RMN "légère" ou de la RMN-IRM à champ tournant.

D'une manière générale, la présente invention vise à permettre de réaliser une structure aimantée induisant un champ homogène longitudinal en son centre.

Ces buts sont atteints, conformément à l'invention, grâce à la structure aimantée définie par la revendication 1 qui a été délimitée par rapport à la structure du brevet US-A-5 014 032.

Des modes de réalisation avantageux sont définis dans les revendications dépendantes 2 à 11.

Selon un mode de réalisation, particulièrement avantageux pour la réalisation de l'assemblage, tous les éléments constitutifs de chaque tranche de la structure aimantée annulaire médiane sont non jointifs. Pour une même tranche, ces éléments non jointifs sont plus épais que les éléments jointifs inclus dans une tranche à éléments jointifs et sont donc moins fragiles et ils s'étendent sur un secteur angulaire plus étroit en ménageant des espaces libres entre éléments non jointifs qui facilitent les manipulations lors de l'assemblage.

Les espaces libres entre éléments non jointifs peuvent rester vides ou encore permettre l'insertion d'éléments de réglage mécanique qui peuvent être ou non magnétiques.

Brève description des dessins

D'autres caractéristiques et avantages de l'invention ressortiront de la description suivante de modes particuliers de réalisation donnés à titre d'exemples, en référence aux dessins annexés, sur lesquels :

- la figure 1 est une vue schématique d'ensemble en perspective d'une structure aimantée axisymétrique selon l'invention,
- la figure 2 montre l'orientation de l'aimantation dans une couronne à aimantation radiale divergente utilisable dans une structure aimantée selon l'invention,
- la figure 3 montre l'orientation de l'aimantation dans une couronne à aimantation radiale convergente utilisable dans une structure aimantée selon l'invention,
- la figure 4 montre l'orientation de l'aimantation dans une structure annulaire médiane à aimantation longitudinale utilisable dans une structure aimantée selon l'invention,
- la figure 5 est une représentation schématique de l'orientation de magnétisation des différents éléments constitutifs d'un exemple de structure aimantée selon l'invention à champ induit longitudinal,
- la figure 6 est une vue de dessus montrant une forme possible de structure aimantée annulaire médiane avec une division en secteurs contigus,
- la figure 7 est une vue de dessus montrant une forme possible de structure aimantée annulaire médiane avec une division en secteurs non jointifs,
- la figure 8 est une vue en perspective d'un exemple de réalisation d'une structure aimantée selon l'invention à section polygonale et structure aimantée annulaire médiane comportant une division en secteurs contigus,
- la figure 9 est une vue en perspective d'un exemple de réalisation d'une structure aimantée selon l'invention à section polygonale et structure aimantée annulaire médiane comportant une division en secteurs non jointifs, les secteurs des diverses tranches étant superposés,
- la figure 10 est une vue en perspective d'un exemple de réalisation d'une structure aimantée selon l'invention à section polygonale et structure aimantée annulaire médiane comportant une division en secteurs non jointifs, les secteurs de chaque tranche étant décalés par rapport aux secteurs des tranches immédiatement adjacentes, et
- la figure 11 est une vue en perspective d'un exemple de réalisation d'une structure aimantée selon l'invention à section polygonale et structure aimantée annulaire médiane comportant une division en secteurs non jointifs, les secteurs des diverses tranches étant alternativement décalés par rapport aux secteurs d'une tranche immédiatement adjacente et superposés aux secteurs d'une tranche immédiatement adjacente.

**EP 2 470 922 B1**

<u>Description détaillée des modes de réalisation préférentiels</u>

D'une façon générale, la présente invention concerne un mode d'assemblage de pièces aimantées afin de créer un champ magnétique homogène et intense au centre de la structure. Le champ induit au centre est orienté selon l'axe de la structure. Le champ obtenu peut être rendu arbitrairement homogène en choisissant le nombre et les dimensions des éléments en respectant certaines règles générales qui seront rappelées ci-dessous. Une telle structure est particulièrement intéressante pour la RMN et l'IRM.

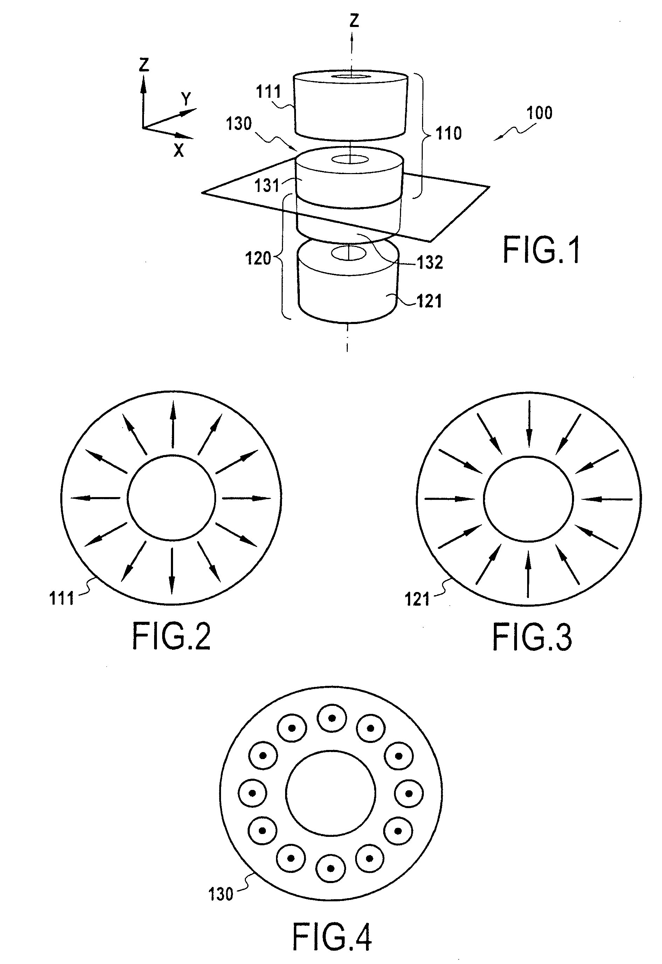

Si l'on considère la figure 1, on voit une structure aimantée essentiellement axisymétrique qui est un assemblage d'éléments cylindriques annulaires constituant des aimants permanents. Ces éléments annulaires sont alignés selon un même axe longitudinal z et sont symétriques par rapport à un plan P. Le centre de la région d'intérêt où doit être créé un champ intense et homogène est situé à l'intersection de l'axe z et du plan P. La structure d'ensemble est cylindrique avec un trou central qui s'étend le long de l'axe z et permet d'accéder au centre de la région d'intérêt.

De façon plus particulière, on voit sur la figure 1 un dispositif 100 constituant un assemblage hybride de structures aimantées en forme de couronnes et comprenant d'une part des première et deuxième structures aimantées annulaires 111, 121 disposées de façon symétrique par rapport au plan P qui est perpendiculaire à l'axe longitudinal z et contient la zone d'intérêt centrale, et d'autre part une troisième structure aimantée annulaire 130 interposée entre les structures 111 et 121 en forme de couronnes et également disposée de façon symétrique par rapport au plan P avec deux parties 131, 132.

On obtient ainsi deux ensembles 110 et 120 symétriques par rapport au plan P. L'ensemble 110 comprend la couronne 111 et la moitié 131 de la structure médiane 130, tandis que l'ensemble 120 comprend la couronne 121 et la moitié 132 de la structure médiane 130. La symétrie par rapport au plan P permet d'annuler tous les termes impairs dans le développement en harmoniques sphériques solides réguliers de la composante $B_z$ du champ magnétique produit au voisinage du centre de la zone d'intérêt.

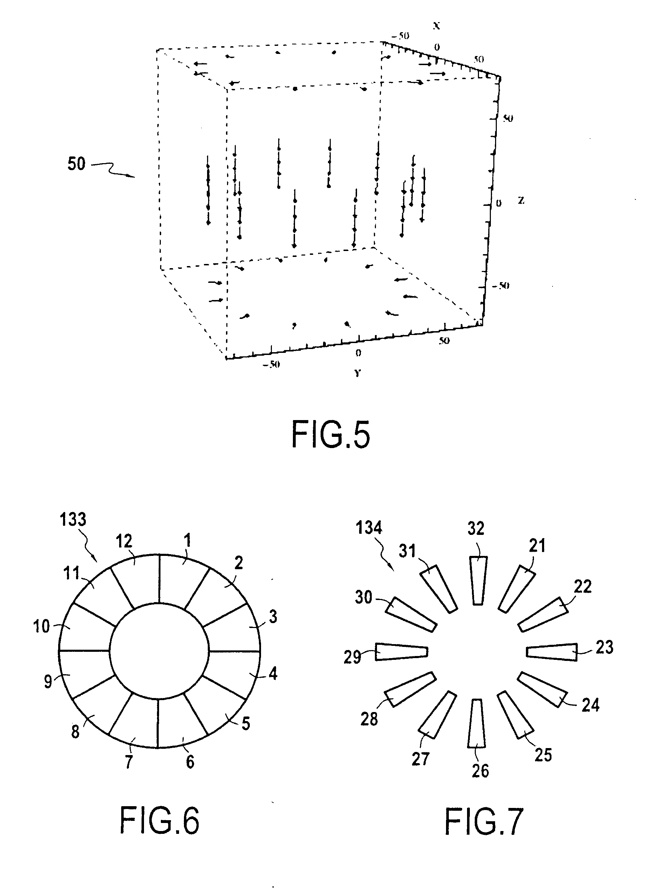

La couronne aimantée 111 est aimantée radialement par rapport à l'axe z avec une aimantation divergente (voir figure 2) tandis que la couronne aimantée 121 est aimantée radialement par rapport à l'axe z avec une aimantation convergente (voir figure 3). La structure aimantée médiane 132 est aimantée selon l'axe longitudinal z (voir figure 4). Il est ainsi créé une structure hybride 50 comme représenté sur la figure 5 où l'on voit l'orientation de l'aimantation des différentes pièces constitutives de la structure aimantée.

La structure aimantée médiane 130 à aimantation longitudinale est divisée en tranches relativement fines selon l'axe z et peut comprendre par exemple quatre tranches, tandis que les couronnes 111, 121 à aimantation radiale peuvent ne comprendre qu'une tranche épaisse.

Comme on peut le voir sur la figure 6, chaque tranche 133 de la structure aimantée médiane 130 peut être divisée en éléments constitutifs en forme de secteurs contigus identiques régulièrement répartis repérés par les numéros de référence 1 à 12 sur la figure 6. L'invention n'est toutefois pas limitée à un nombre de secteurs égal à 12 et ce nombre pourrait être différent de 12. Le nombre de douze secteurs par anneau constitue un mode de réalisation préférentiel avec un ordre d'homogénéité satisfaisant. Un nombre de secteurs inférieur, par exemple dix secteurs ou même moins, permet également des résultats utiles, mais avec une homogénéité légèrement dégradée. Si l'on souhaite améliorer encore plus l'homogénéité, on peut diviser chaque tranche en plus de douze secteurs.

Les couronnes aimantées 111 et 121 sont également divisées de la même manière en éléments constitutifs en forme de secteurs contigus identiques régulièrement répartis. Ceci constitue un mode de réalisation préférentiel simple et efficace, les secteurs médians permettant eux-mêmes d'effectuer certains réglages a posteriori. Toutefois, en cas de besoin les couronnes aimantées 111 et 121 pourraient elles-mêmes être formées d'éléments constitutifs en forme de secteurs identiques non jointifs régulièrement répartis, afin d'offrir une possibilité supplémentaire de réglage fin a posteriori.

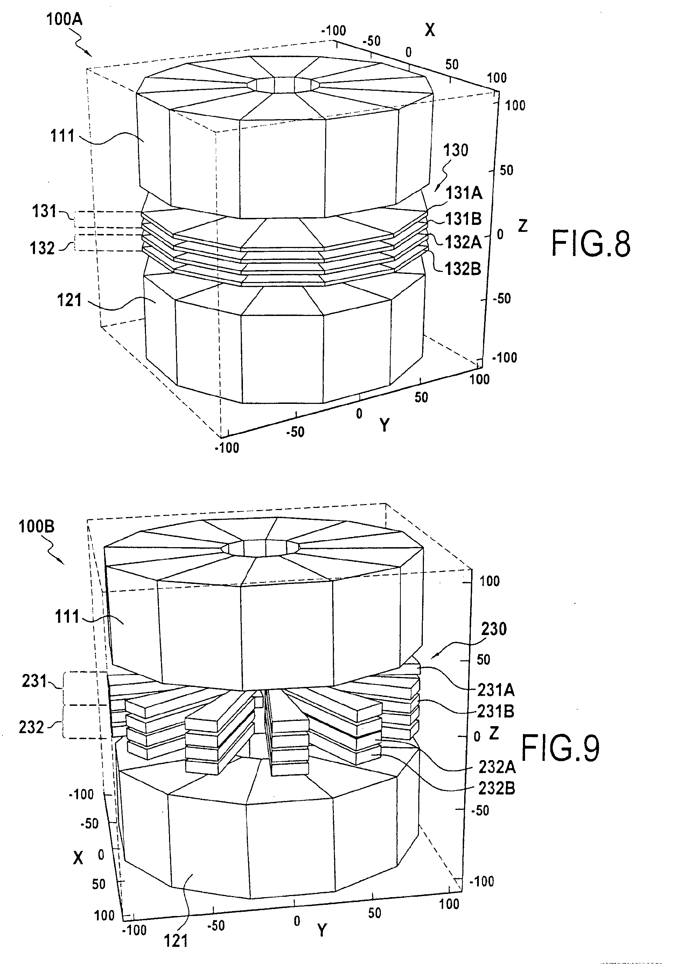

D'une manière générale, il est avantageux de réaliser chaque structure cylindrique annulaire sous la forme d'une structure polyédrique régulière comprenant un ensemble de N segments identiques. Chaque segment est ainsi un prisme droit de section trapézoïdale isocèle et son aimantation est parallèle à la hauteur du prisme ou formant un angle prédéterminé par rapport à cette hauteur. Un exemple d'une telle structure 100A est représenté sur la figure 8. On voit que dans le cas où la structure aimantée médiane 130 est divisée en secteurs contigus, par exemple comme représenté sur la figure 6, les diverses tranches 131A, 131B, 132A, 132B constituant cette structure aimantée médiane sont relativement fines, ce qui peut conférer une certaine fragilité à ces éléments.

Chaque segment élémentaire en forme de secteur d'une tranche de la structure aimantée médiane 130 peut être non contigu par rapport aux segments voisins. Un mode de réalisation d'une tranche élémentaire 134 de la structure aimantée médiane 130 avec des segments élémentaires 21 à 32 non jointifs est représenté sur la figure 7. On décrira plus loin en référence aux figures 9 à 11 divers exemples de réalisation de structures aimantées 100B, 100C, 100D avec une structure aimantée médiane 230, 330, 430 composée de tranches formées chacune d'un ensemble de segments élémentaires en forme de secteurs non jointifs, ce qui facilite les ajustements après assemblage

Comme on l'a déjà indiqué, la structure aimantée annulaire médiane 130 est divisée en tranches selon l'axe

**4**

longitudinal z. Ces tranches sont dans tous les cas d'une épaisseur plus réduite selon l'axe z que celle des structures 111 et 121, mais une constitution des tranches avec des segments élémentaires disjoints permet d'avoir une épaisseur plus importante pour chaque segment par rapport à une réalisation de la structure aimantée annulaire médiane avec des segments élémentaires jointifs. Les divers modes de réalisation décrits peuvent se combiner entre eux et par exemple, il serait possible de réaliser une structure aimantée annulaire médiane comportant certaines tranches à segments élémentaires contigus et certaines tranches à segments élémentaires non jointifs, dès lors que l'on respecte la symétrie par rapport au plan P perpendiculaire à l'axe z.

On décrira brièvement ci-dessous quelques notions de base utiles à la compréhension de l'invention.

Dans la plupart des cas, la région d'intérêt (RoI) est en dehors de la région des sources de champ magnétique et l'on peut définir un potentiel magnétique pseudo-scalaire tel que :

$$\vec{B} = -\vec{\nabla}\Phi^*$$

Ce potentiel vérifie l'équation de Laplace:

$$\Delta\Phi^* = 0$$

Dans le cas qui nous intéresse, on peut représenter la région d'intérêt comme une sphère dont le centre sera appelé l'origine. L'équation de Laplace peut s'exprimer dans un système de coordonnées sphériques et l'on peut obtenir un développement unique du potentiel en harmoniques sphériques, centré sur l'origine. La solution générale pour le potentiel peut alors s'écrire :

$$\Phi^*(r,\theta,\phi) = \sum_{l=0}^{\infty}\sum_{m=-l}^{l}\left[A_{lm}r^l + B_{lm}r^{-(l+1)}\right]Y_{lm}(\theta,\phi),$$

où:

$$Y_{lm}(\theta,\phi) = \sqrt{\frac{2l+1}{4\pi}\frac{(l-m)!}{(l+m)!}}P_l^m(\cos\theta)\exp(im\phi)$$

On peut retenir que le potentiel existe seulement dans les zones vides de l'espace. On peut diviser l'espace en deux zones où le potentiel existe : à l'intérieur de la plus grande sphère centrée sur l'origine qui ne contient aucune source et à l'extérieur de la plus petite sphère centrée sur l'origine qui contient toutes les sources.

Lorsque les sources sont situées à l'extérieur de cette sphère, on peut écrire le développement de la façon suivante :

$$\Phi^*(r,\theta,\phi) = \frac{1}{\mu_0}\left\{Z_0 + \sum_{n=1}^{\infty}r^n\left[Z_nP_n(\cos\theta) + \sum_{m=1}^{n}\left(X_n^m\cos(m\phi) + Y_n^m\sin(m\phi)\right)P_n^m(\cos\theta)\right]\right\}$$

Où les termes $Z_n$ sont appelés les termes axiaux et les termes $X_n^m$ et $Y_n^m$ sont appelés les termes non-axiaux.

A partir de cette équation, on peut conclure que pour obtenir un champ homogène, il faut trouver une distribution de la source qui crée un potentiel pour lequel le développement ne contient que le terme $Z_1$ (dès lors que le champ est la dérivée du potentiel et que le terme $Z_0$ pour le champ correspond au terme $Z_1$ pour le potentiel). Ceci est impossible au sens strict, mais on peut supprimer autant de termes que nécessaire pour obtenir l'homogénéité désirée dans un rayon r donné puisque le champ varie comme $\left(\dfrac{r}{a}\right)^{n}$ où a est une constante caractéristique de la géométrie. En conclusion, pour obtenir l'homogénéité souhaitée, il faut supprimer les k premiers ordres jusqu'à ce que $\left(\dfrac{r}{a}\right)^{k+1}$ soit suffisamment petit.

De cette équation on peut aussi déduire qu'une structure axisymétrique est avantageuse dans la mesure où elle supprime les termes non axiaux. Si l'on veut obtenir une homogénéité de l'ordre n, la symétrie de rotation en n garantit qu'aucun terme non axial n'existe avant l'ordre n.
Une fois que les termes non axiaux ont été éliminés, il reste les termes axiaux.

Une autre symétrie intéressante est la symétrie en miroir ou l'antisymétrie qui ne laisse que les termes axiaux pairs (ou impairs). Il est alors possible d'éliminer arbitrairement les ordres 2p en agençant p+1 sources indépendantes.

Une optimisation non-linéaire est ainsi possible. Par ailleurs la solution trouvée est extensible. Le système peut être étendu de façon uniforme dans toutes les dimensions (de façon homothétique) et peut être rendu aussi grand que possible, les propriétés d'homogénéité n'étant pas affectées et l'amplitude du champ magnétique restant constante.

La géométrie d'un dispositif selon l'invention admet un plan de symétrie P contenant le centre de la structure et orthogonal à l'axe z. L'axe z est l'axe de symétrie de la structure qui est composée de divers éléments coaxiaux de forme cylindrique percés en leur centre pour dégager l'accès au centre. Un schéma de base de la structure est visible en Figure 1. Comme on l'a déjà indiqué plus haut un cylindre principal est décomposé en deux disques ou couronnes 111, 121 à aimantation radiale disposés de part et d'autre du plan de symétrie P, l'une des couronnes (couronne 111) ayant une aimantation dirigée vers l'extérieur tandis que l'autre couronne (couronne 121) a son aimantation dirigée vers l'intérieur. Un ensemble de tranches d'une structure annulaire 130 interposée entre les couronnes 111 et 121 présente une aimantation longitudinale selon l'axe z.

La figure 5 montre l'ensemble des orientations des aimantations au sein de la structure d'ensemble 50. Dans l'exemple de la figure 5, le champ créé au centre de la structure aimantée axisymétrique est dirigé vers le haut.

La position et les dimensions selon z des éléments à aimantation longitudinale constituant la structure aimantée annulaire médiane 130 permettent de contrôler l'homogénéité (suivant la méthode de suppression des termes axiaux). Par ailleurs, la symétrie plane permet de supprimer un terme axial sur deux dans le développement en harmoniques sphériques. Ainsi si l'on veut atteindre une homogénéité à l'ordre 2p, il faut p+1 éléments (puisqu'il reste à supprimer p termes).

Des éléments parfaitement cylindriques comme représenté sur la figure 1 peuvent être envisagés, mais ne sont pas forcément les plus adaptés pour la fabrication (imperfections géométriques, besoin de réglages après assemblage). On peut par contre approcher le cylindre par une forme polygonale admettant des secteurs. Cette forme doit présenter au moins une symétrie $2p_0$ pour éliminer tous les termes non-axiaux jusqu'à l'ordre $2p_0$. On doit alors utiliser $p_0+1$ tranches pour éliminer les termes axiaux restants et obtenir un champ homogène jusqu'à l'ordre $2p_0$. Dans les exemples décrits on a pris en considération une symétrie axiale d'ordre 12 pour s'assurer de l'absence des termes non-axiaux, ce qui implique un dodécagone. Par ailleurs, la suppression des termes axiaux nécessite 6 éléments (4 tranches de la structure aimantée annulaire médiane 130 et les deux couronnes 111 et 121) pour atteindre l'ordre 12.

Les figures 8 à 11 présentent des modes de réalisation dont la géométrie satisfait les diverses conditions pour l'homogénéité.

La figure 8 montre une structure 100A avec des tranches 131A, 131B, 132A, 132B de la structure annulaire médiane à aimantation longitudinale qui sont composées chacune de segments élémentaires contigus. De telles tranches doivent ainsi être relativement fines, ce qui peut rendre la fabrication assez délicate. Pour remédier à ce problème, des modes de réalisation préférentiels ont été représentés sur les figures 9 à 11. Dans ce cas, les structures 100B, 100C et 100D données à titre d'exemples comportent une structure annulaire médiane à aimantation longitudinale qui comprend des tranches constituées de segments élémentaires non jointifs qui s'étendent sur un secteur angulaire réduit et ménagent ainsi entre eux des espaces libres. Ces segments élémentaires non jointifs permettent de former des tranches plus épaisses et donc moins fragiles que les tranches constituées de segments élémentaires contigus. Les segments élémentaires non-jointifs offrent également la possibilité d'un ajustement en trois dimensions après montage pour corriger des défauts de fabrication ou d'assemblage.

Dans le mode de réalisation de la figure 9, qui montre une structure axisymétrique 100B dans laquelle les couronnes 111 et 121 à aimantation radiale peuvent être identiques aux couronnes 111 et 121 du mode de réalisation de la figure 8, les éléments non jointifs constitutifs des diverses tranches 231A, 231B, 232A, 232B de la structure aimantée annulaire médiane 230 sont superposés les uns aux autres.

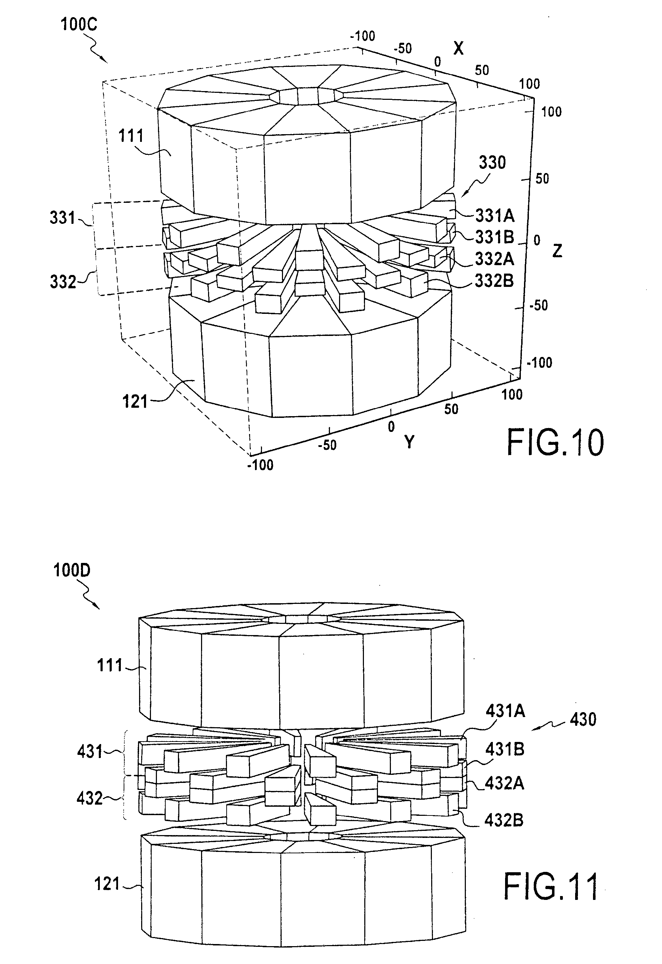

Dans le mode de réalisation de la figure 10, qui montre une structure 100C dans laquelle les couronnes 111 et 121 à aimantation radiale peuvent également être identiques aux couronnes 111 et 121 des modes de réalisation des figures 8 et 9, les éléments non jointifs constitutifs de chaque tranche 331A, 331B, 332A, 332B de la structure aimantée annulaire médiane 330 sont décalés angulairement (par exemple de 30°) par rapport aux éléments non jointifs constitutifs des autres tranches immédiatement adjacentes. Ceci facilite l'accès pour installer des dispositifs d'ajustement après assemblage.

Dans le mode de réalisation de la figure 11, qui montre une structure 100D dans laquelle les couronnes 111 et 121 à aimantation radiale peuvent également être identiques aux couronnes 111 et 121 des modes de réalisation des figures 8 à 10, les éléments non jointifs constitutifs des tranches 431A, 431B, 432A, 432B de la structure aimantée annulaire médiane 430 sont alternativement décalés angulairement par rapport aux éléments non jointifs constitutifs d'une autre tranche immédiatement adjacente et superposés par rapport aux éléments non jointifs constitutifs d'une autre tranche immédiatement adjacente.

## Revendications

1. Structure aimantée induisant dans une zone d'intérêt centrale un champ magnétique homogène orienté selon un axe longitudinal (z) de la structure, la structure aimantée étant appliquée à un appareil de Résonance Magnétique Nucléaire et comprenant des première et deuxième couronnes aimantées (111, 121) disposées de façon symétrique par rapport à un plan (P) qui est perpendiculaire audit axe longitudinal (z) et contient ladite zone d'intérêt centrale, et une structure aimantée annulaire médiane (130) interposée entre les première et deuxième couronnes aimantées (111, 121) et également disposée de façon symétrique par rapport audit plan (P), la première couronne aimantée (111) étant aimantée radialement par rapport à l'axe longitudinal (z) avec une aimantation divergente, la deuxième couronne aimantée (121) étant aimantée radialement par rapport à l'axe longitudinal (z) avec une aimantation convergente, la structure aimantée annulaire médiane (130) étant divisée en au moins deux tranches (131A, 131B, 132A, 132B) selon l'axe longitudinal (z), et les première et deuxième couronnes aimantées (111, 121) ainsi que les diverses tranches (131A, 131B, 132A, 132B) de la structure aimantée annulaire médiane (130) étant divisées chacune en éléments constitutifs identiques en forme de secteurs (1 à 12 ; 21 à 32) régulièrement répartis, **caractérisée en ce que** la structure aimantée annulaire médiane (130), et donc chacun de ses éléments constitutifs (1 à 12 ; 21 à 32), sont aimantés selon l'axe longitudinal (z).

2. Structure aimantée selon la revendication 1, **caractérisée en ce que** la structure aimantée annulaire médiane (130) est divisée en au moins quatre tranches (131A, 131B, 132A, 132B).

3. Structure aimantée selon la revendication 1 ou la revendication 2, **caractérisée en ce que** les première et deuxième couronnes aimantées (111, 121) présentent dans le sens de l'axe longitudinal (z) une épaisseur plus grande que celle de chaque tranche (131A, 131B, 132A, 132B) de la structure aimantée annulaire médiane (130).

4. Structure aimantée selon l'une quelconque des revendications 1 à 3, **caractérisée en ce que** les première et deuxième couronnes aimantées (111, 121) et chaque tranche (131A, 131B, 132A, 132B) de la structure aimantée annulaire médiane (130) sont divisées en au moins douze éléments constitutifs en forme de secteurs.

5. Structure aimantée selon l'une quelconque des revendications 1 à 4, **caractérisée en ce que** les parois cylindriques intérieure et extérieure des première et deuxième couronnes aimantées (111, 121) et de la structure aimantée annulaire médiane (130) présentent une section polygonale dans un plan perpendiculaire audit axe longitudinal (z).

6. Structure aimantée selon l'une quelconque des revendications 1 à 5, **caractérisée en ce que** tous les éléments constitutifs des première et deuxième couronnes aimantées (111, 121) sont jointifs.

7. Structure aimantée selon l'une quelconque des revendications 1 à 6, **caractérisée en ce que** tous les éléments constitutifs de chaque tranche (131A, 131B, 132A, 132B) de la structure aimantée annulaire médiane (130) sont jointifs.

8. Structure aimantée selon l'une quelconque des revendications 1 à 6, **caractérisée en ce que** tous les éléments constitutifs de chaque tranche de la structure aimantée annulaire médiane (230 ; 330 ; 430) sont non jointifs.

9. Structure aimantée selon la revendication 8, **caractérisée en ce que** les éléments non jointifs constitutifs des diverses tranches (231A, 231B, 232A, 232B) de la structure aimantée annulaire médiane (230) sont superposés les uns sur les autres en étant alignés les uns par rapport aux autres selon l'axe longitudinal.

**10.** Structure aimantée selon la revendication 8, **caractérisée en ce que** les éléments non jointifs constitutifs de chaque tranche (331A, 331B, 332A, 332B) de la structure aimantée annulaire médiane (330) sont décalés angulairement par rapport aux éléments non jointifs constitutifs des autres tranches immédiatement adjacentes.

**11.** Structure aimantée selon la revendication 8, **caractérisée en ce que** les éléments non jointifs constitutifs des tranches (431A, 431B, 432A, 432B) de la structure aimantée annulaire médiane (430) sont alternativement décalés angulairement par rapport aux éléments non jointifs constitutifs d'une autre tranche immédiatement adjacente et superposés par rapport aux éléments non jointifs constitutifs d'une autre tranche immédiatement adjacente en étant alignés avec ces derniers selon l'axe longitudinal.

**Patentansprüche**

**1.** Magnetstruktur, die in einem mittleren Bereich von Interesse ein entlang einer Längsachse (z) der Struktur ausgerichtetes homogenes Magnetfeld induziert, wobei die Magnetstruktur auf ein Kernspinresonanzgerät angewandt ist und einen ersten und einen zweiten Magnetkranz (111, 121), die in Bezug auf eine Ebene (P), welche zu der Längsachse (z) senkrecht verläuft und den mittleren Bereich von Interesse enthält, symmetrisch angeordnet sind, sowie eine mittlere ringförmige Magnetstruktur (130), die zwischen dem ersten und dem zweiten Magnetkranz (111, 121) eingefügt und ebenfalls in Bezug auf die Ebene (P) symmetrisch angeordnet ist, umfasst, wobei der erste Magnetkranz (111) in Bezug auf die Längsachse (z) mit einer divergenten Magnetisierung radial magnetisiert ist, wobei der zweite Magnetkranz (121) in Bezug auf die Längsachse (z) mit einer konvergenten Magnetisierung radial magnetisiert ist, wobei die mittlere ringförmige Magnetstruktur (130) entlang der Längsachse (z) in wenigstens zwei Scheiben (131A, 131 B, 132A, 132B) unterteilt ist, und wobei der erste und der zweite Magnetkranz (111, 121) sowie die verschiedenen Scheiben (131 A, 131 B, 132A, 132B) der mittleren ringförmigen Magnetstruktur (130) jeweils in identische sektorenförmige Bestandteile (1 bis 12; 21 bis 32), welche gleichmäßig verteilt sind, unterteilt sind, **dadurch gekennzeichnet, dass** die mittlere ringförmige Magnetstruktur (130) und folglich ein jedes ihrer Bestandteile (1 bis 12; 21 bis 32) entlang der Längsachse (z) magnetisiert sind.

**2.** Magnetstruktur nach Anspruch 1, **dadurch gekennzeichnet, dass** die mittlere ringförmige Magnetstruktur (130) in wenigstens vier Scheiben (131 A, 131 B, 132A, 132B) unterteilt ist.

**3.** Magnetstruktur nach Anspruch 1 oder Anspruch 2, **dadurch gekennzeichnet, dass** der erste und der zweite Magnetkranz (111, 121) in Richtung der Längsachse (z) eine Dicke aufweisen, die größer als diejenige einer jeden Scheibe (131A, 131 B, 132A, 132B) der mittleren ringförmigen Magnetstruktur (130) ist.

**4.** Magnetstruktur nach einem der Ansprüche 1 bis 3, **dadurch gekennzeichnet, dass** der erste und der zweite Magnetkranz (111, 121) und jede Scheibe (131A, 131B, 132A, 132B) der mittleren ringförmigen Magnetstruktur (130) in wenigstens zwölf sektorenförmige Bestandteile unterteilt sind.

**5.** Magnetstruktur nach einem der Ansprüche 1 bis 4, **dadurch gekennzeichnet, dass** die zylindrische Innenwand und die zylindrische Außenwand des ersten und des zweiten Magnetkranzes (111, 121) und der mittleren ringförmigen Magnetstruktur (130) einen polygonalen Querschnitt in einer Ebene senkrecht zu der Längsachse (z) aufweisen.

**6.** Magnetstruktur nach einem der Ansprüche 1 bis 5, **dadurch gekennzeichnet, dass** alle Bestandteile des ersten und des zweiten Magnetkranzes (111, 121) aneinanderstoßend sind.

**7.** Magnetstruktur nach einem der Ansprüche 1 bis 6, **dadurch gekennzeichnet, dass** alle Bestandteile einer jeden Scheibe (131A, 131 B, 132A, 132B) der mittleren ringförmigen Magnetstruktur (130) aneinanderstoßend sind.

**8.** Magnetstruktur nach einem der Ansprüche 1 bis 6, **dadurch gekennzeichnet, dass** alle Bestandteile einer jeden Scheibe der mittleren ringförmigen Magnetstruktur (230; 330; 430) nicht aneinanderstoßend sind.

**9.** Magnetstruktur nach Anspruch 8, **dadurch gekennzeichnet, dass** die nicht aneinanderstoßenden Bestandteile der verschiedenen Scheiben (231A, 231 B, 232A, 232B) der mittleren ringförmigen Magnetstruktur (230) übereinander angeordnet und dabei entlang der Längsachse zueinander ausgerichtet sind.

**10.** Magnetstruktur nach Anspruch 8, **dadurch gekennzeichnet, dass** die nicht aneinanderstoßenden Bestandteile einer jeden Scheibe (331A, 331 B, 332A, 332B) der mittleren ringförmigen Magnetstruktur (330) gegenüber den nicht aneinanderstoßenden Bestandteilen der anderen, unmittelbar angrenzenden Scheiben winkelmäßig versetzt sind.

11. Magnetstruktur nach Anspruch 8, **dadurch gekennzeichnet, dass** die nicht aneinanderstoßenden Bestandteile der Scheiben (431A, 431 B, 432A, 432B) der mittleren ringförmigen Magnetstruktur (430) abwechselnd gegenüber den nicht aneinanderstoßenden Bestandteilen einer anderen, unmittelbar angrenzenden Scheibe winkelmäßig versetzt und gegenüber den nicht aneinanderstoßenden Bestandteilen einer anderen, unmittelbar angrenzenden Scheibe übereinander angeordnet und dabei mit letzteren entlang der Längsachse ausgerichtet sind.

**Claims**

1. A magnetized structure that induces in a central area of interest a homogeneous magnetic field oriented along a longitudinal axis (z) of the structure, the magnetized structure being applied to a Magnetic Nuclear Resonance apparatus and comprising first and second magnetized rings (111, 121) disposed symmetrically relative to a plane (P) that is perpendicular to said longitudinal axis (z) and that contains said central area of interest, and one median annular magnetized structure (130) disposed between the first and second magnetized rings (111, 121) and also disposed symmetrically relative to said plane (P), the first magnetized ring (111) being magnetized radially relative to the longitudinal axis (z) with divergent magnetization, the second magnetized ring (121) being magnetized radially relative to the longitudinal axis (z) with convergent magnetization, the median annular magnetized structure (130) being divided into at least two slices (131A, 131B, 132A, 132B) along the longitudinal axis (z) and the first and second magnetized rings (111, 121) and the various slices (131A, 131B, 132A, 132B) of the median magnetized structure (130) being each divided into identical components in the form of regularly distributed sectors (1 to 12; 21 to 32), **characterized in that** the median annular magnetized structure (130) and each said component (1 to 12; 21 to 32) are magnetized along the longitudinal axis (z),

2. A magnetized structure according to claim 1, **characterized in that** the median annular magnetized structure (130) is divided into at least four slices (131A, 131B, 132A, 132B).

3. A magnetized structure according to claim 1 or claim 2, **characterized in that** the first and second magnetized rings (111, 121) have in the direction of the longitudinal axis (z) a thickness greater than that of each slice (131A, 131B, 132A, 132B) of the median annular magnetized structure (130).

4. A magnetized structure according to any one of claims 1 to 3, **characterized in that** the first and second magnetized rings (111, 121) and each slice (131A, 131B, 132A, 132B) of the median annular magnetized structure (130) are divided into at least twelve sector-shaped components.

5. A magnetized structure according to any one of claims 1 to 4, **characterized in that** the interior and exterior cylindrical walls of the first and second magnetized rings (111, 121) and the median annular magnetized structure (130) have a polygonal section in a plane perpendicular to said longitudinal axis (z).

6. A magnetized structure according to any one of claims 1 to 5, **characterized in that** all the components of the first and second magnetized rings (111, 121) are contiguous.

7. A magnetized structure according to any one of claims 1 to 6, **characterized in that** all the components of each slice (131A, 131B, 132A, 132B) of the median annular magnetized structure (130) are contiguous.

8. A magnetized structure according to any one of claims 1 to 6, **characterized in that** all the components of each slice of the median annular magnetized structure (230; 330; 430) are non-contiguous.

9. A magnetized structure according to claim 8, **characterized in that** the non-contiguous components of the various slices (231A, 231B, 232A, 232B) of the median annular magnetized structure (230) are superposed on each other and aligned with each other along the longitudinal axis.

10. A magnetized structure according to claim 8, **characterized in that** the non-contiguous components of each slice (331A, 331B, 332A, 332B) of the median annular magnetized structure (330) are offset angularly relative to the non-contiguous components of the other immediately adjacent slices.

**11.** A magnetized structure according to claim 8, **characterized in that** the non-contiguous components of the slices (431A, 431B, 432A, 432B) of the median annular magnetized structure (430) are alternately offset angularly relative to the non-contiguous components of the another immediately adjacent slice and superposed relative to the non-contiguous components of another immediately adjacent slice, being aligned therewith along the longitudinal axis.

FIG.1

FIG.2

FIG.3

FIG.4

**FIG.5**

**FIG.6**

**FIG.7**

FIG.8

FIG.9

FIG.10

FIG.11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5014032 A, Guy Aubert
- US 2960649 A, Bloch
- WO 2006024775 A